**Europäisches Patentamt**

**European Patent Office**

**Office européen des brevets**

(11) Veröffentlichungsnummer : **0 508 975 A1**

# (12) EUROPÄISCHE PATENTANMELDUNG

(21) Anmeldenummer : **92890057.0**

(22) Anmeldetag : **13.03.92**

(51) Int. Cl.$^5$ : **H01L 27/02**

(30) Priorität : **13.03.91 AT 561/91**

(43) Veröffentlichungstag der Anmeldung :
**14.10.92 Patentblatt 92/42**

(84) Benannte Vertragsstaaten :
**AT BE CH DE DK ES FR GB IT LI SE**

(71) Anmelder : **AUSTRIA MIKRO SYSTEME INTERNATIONAL GESELLSCHAFT m.b.H. (Austria Micro Systems International Gesellschaft m.b.H.) Schloss Premstätten, Tobelbachstrasse A-8141 Unterpremstätten (AT)**

(72) Erfinder : **Dietrich, Armgarth, Dr. Dipl.-Ing. Bischofsweg 1 O-8060 Dresden (DE)**

(74) Vertreter : **Haffner, Thomas M., Dr. Patentanwaltskanzlei Dipl.-Ing. Adolf Kretschmer Dr. Thomas M. Haffner Schottengasse 3a A-1014 Wien (AT)**

(54) **Schutzschaltung für integrierte CMOS/BICMOS-Schaltungsanordnungen und Verfahren zur Herstellung einer derartigen Schutzschaltung.**

(57) Bei einer Schutzschaltung für die Gate-Elektrode von integrierten CMOS/BICMOS-Schaltungsanordnungen, bei welcher in der Zuleitung des zu schützenden Gates ein Feld-Effekt-Transistor (FET) vom selbstleitenden Typ angeordnet ist, dessen Gate an Masse liegt, ist der FET als n-Kanal-JFET (10) ausgebildet, wobei sich ein elektrisches Ersatzschaltbild ergibt, bei welchem ein Eingang (1) über einen ersten Widerstand (2) auf die Kathode (3) einer ersten Zenerdiode (5) geführt ist, die Anode (4) der ersten Zenerdiode (5) an Masse (15) geschaltet ist, ein zweiter Widerstand (6) zwischen der Kathode (3) der ersten Zenerdiode (5) und dem Drain (7) des n-Kanal-JFET (10) vorgesehen ist, das Gate (8) des n-Kanal-JFET (10) mit der Kathode einer zweiten Zenerdiode (13) zusammengeschaltet ist, die Anode (12) der zweiten Zenerdiode (13) mit Masse (15) verbunden ist und zwischen dem Source (9) des n-Kanal-JFET (10) und einem Knotenpunkt (16) der zu schützenden Gate-Elektroden ein weiterer Widerstand (14) vorgesehen ist.

Zur Herstellung einer derartigen Schutzschaltung wird bei einem n-Wannen-CMOS-Prozeß die Zenerdiode (5) aus einem Kopfteil der n-Wanne ausgebildet, der Widerstand (6) wird durch einen länglichen Teil der n-Wanne realisiert, der n-Kanal-JFET (10) wird aus dem unter dem p$^+$-Gate (8) liegenden Teil der n-Wanne gebildet und die Zenerdiode (13) ist im Bereich des n$^+$-Source (9) und des p$^+$-Gate (8) wirksam. Bei einem n-Wannen-BICMOS-Prozeß wird das p-Gate (8) durch die Basisdiffusion erzeugt und die Zenerdiode (13) wird durch den beim BICMOS-Prozeß zur Verfügung stehenden Emitter-Basis-pn-Übergang realisiert.

FIG. 1

Die Erfindung betrifft eine Schutzschaltung für die Gate-Elektrode von integrierten CMOS/BICMOS-Schaltungsanordnungen, bei welcher in der Zuleitung des zu schützenden Gates ein Feld-Effekt-Transistor (FET) vom selbstleitenden Typ angeordnet ist, dessen Gate an Masse liegt, sowie ein Verfahren zur Herstellung derartiger Schutzschaltungen.

Bei den bekannten Schutzschaltungen besteht das Netzwerk aus Widerständen, MOS-Transistoren und Dioden. Die Widerstände bestehen meist aus diffundierten Widerstandsbahnen und/oder Polysilizium-Widerstandsbahnen. Die verwendeten MOS-Transistoren und Dioden sind durch die zur Verfügung stehenden Prozeßschritte realisiert. Bei der elektrostatischen Entladung (ESD) können kurzzeitig erhebliche Energien freigesetzt werden, so daß die Widerstandsbahnen, das Gateoxid und/oder die pn-Dioden zerstört werden, weil erhebliche Ströme fließen. Anderseits können nun nicht die Vorwiderstände beliebig vergrößert werden, weil dann die dynamischen Eigenschaften verschlechtert werden und der Platzbedarf beträchtlich ansteigt.

Beispiele für solche Anordnungen sind aus der EP-A-102 647 "Input protection device for CMOS device", aus der US PS 4 739 378 "Protection of integrated circuits from electric discharge", aus der US-PS 4 750 078 "Semiconductor protection circuit having both positive and negative high voltage protection" und aus der US-PS 4 750 081 "Phantom ESD protection circuit employing E-field crowding" bekannt.

Nach der US-PS 4 739 378 wird z.B. eine laterale und vertikale Zenerdiode unterhalb der Bondinsel angeordnet.

In der US-PS 4 750 078 wird eine Schutzschaltung aus einem Bipolartransistor und MOS-Transistoren vorgeschlagen, die zwischen dem Eingang und der Versorgungsspannung angeordnet ist.

Nach der US-PS 4 750 081 werden z.B. Schutzdioden unter allen Ecken der Bondinsel angeordnet.

Alle diese Anordnungen haben den Nachteil, daß die Dioden- oder Transistoranordnungen zwar die Eingangsspannung begrenzen, daß aber trotzdem bei sehr hohen Spannungen ein Teil der Energie zum Gate gelangt und dieses Gate zerstören kann.

Ziel und Zweck der Erfindung ist es, eine Schutzschaltung anzugeben, die wenig Platz auf dem Siliziumchip beansprucht, die die dynamischen Eigenschaften der Schaltung kaum beeinflußt und die auch die ESD-Anforderungen erfüllt.

Zur Lösung dieser Aufgabe besteht bei einer Schutzschaltung für integrierte CMOS/BICMOS-Schaltungsanordnungen die Erfindung im wesentlichen darin, daß der FET als n-Kanal JFET ausgebildet ist, wobei sich ein elektrisches Ersatzschaltbild ergibt, bei welchem ein Eingang über einen ersten Widerstand auf die Kathode einer ersten Zenerdiode geführt ist, die Anode der ersten Zenerdiode an Masse angeschaltet ist, ein zweiter Widerstand zwischen der Kathode der ersten Zenerdiode und dem Drain des n-Kanal-JFET vorgesehen ist, das Gate des n-Kanal-JFET mit der Kathode einer zweiten Zenerdiode zusammengeschaltet ist, die Anode der zweiten Zenerdiode mit Masse verbunden ist und zwischen dem Source des n-Kanal-JFET und einem Knotenpunkt der zu schützenden Gate-Elektroden ein weiterer Widerstand vorgesehen ist. Bei Eingangsspannungen zulässiger Größe ist der n-Kanal-JFET niederohmig und das Signal gelangt vom Eingang über den FET und die mit dessen Source-Drain-Strecke in Reihe liegenden Ohm'schen Widerstände (Bahnwiderstände) nahezu ungeschwächt an den Knotenpunkt der zu schützenden CMOS-Gates. Bei höheren Eingangsspannungen wird an Source und Drain des n-Kanal-JFET der absolute Wert der Pinch-off-Spannung überschritten, so daß der leitende Kanal abgeschnürt wird. Eventuell kapazitiv über den gesperrten FET übertragene Störimpulse werden durch die den CMOS-Gates näher liegende Zenerdiode abgeleitet. Schließlich dient die dem Eingang näher liegende Zenerdiode als Grobschutz für Störspitzen von größenordnungsmäßig mehr als 100 V. Dabei wird die Strombelastung der Zenerdiode durch den zwischen Eingang und Zenerdiode liegenden Ohm'schen Widerstand begrenzt.

Zwischen Source des n-Kanal-JFETs bzw. Kathode der zweiten Zenerdiode und dem Knotenpunkt der CMOS-Gates ist erfindungsgemäß, wie vorstehend erwähnt, ein dritter Widerstand vorgesehen. In Weiterbildung der Erfindung können von diesem Knotenpunkt einzeln oder in Kombination zur positiven Betriebsspannung eine Diode in Durchlaßrichtung und nach Masse eine Diode in Sperrichtung vorgesehen sein, um gegenbenenfalls vom Eingang her bis an die CMOS-Gates vordringende Störspannungen an den positiven bzw. negativen Pol der Betriebsspannung zu klemmen.

Ein erfindungsgemäßes Verfahren zur Herstellung einer Schutzschaltung für integrierte CMOS/BICMOS-Schaltungsanordnung weist die Schritte auf, daß bei einem n-Wannen-CMOS-Prozeß die Zenerdiode aus einem Kopfteil der n-Wanne ausge-bildet wird, daß der Widerstand durch einen länglichen Teil der n-Wanne realisiert wird, daß der n-Kanal-JFET aus dem Teil der n-Wanne gebildet wird, der unter dem $p^+$-Gate liegt, und daß die Zenerdiode im Bereich des $n^+$-Source und des $p^+$-Gate wirksam ist, wobei vorzugsweise der Kopfteil der n-Wanne unter der Bondinsel des Eingangs angeordnet wird.

Alternativ kann bezüglich der Ausbildung des n-Kanal-JFETs so vorgegangen werden, daß bei einem n-Wannen-BICMOS-Prozeß das p-Gate durch die Basisdiffusion erzeugt wird und daß die Zenerdiode durch den beim BICMOS-Prozeß zur Verfügung stehenden Emitter-Basis-pn-Übergang realisiert wird.

Alle vorgenannten Maßnahmen tragen dazu bei, im Zuge der Herstellung von CMOS- oder BICMOS-Schaltungen zusätzliche Herstellungsschritte für die Schutzschaltung möglichst zu vermeiden und die Schutzschaltung platzsparend unterzubringen.

Die Erfindung wird nachstehend an einem Ausführungsbeispiel näher erläutert. In der Zeichnung zeigt: Fig.1 das elektrische Schaltbild; Fig.2 eine integrierte Ausführungsform mit einem lateralen n-Kanal-JFET für einen n-Wannen-CMOS-Prozeß; Fig.3 eine integrierte Ausführungsform mit einem lateralen n-Kanal-JFET für einen n-Wannen-BICMOS-Prozeß und Fig.4 ein Layoutbeispiel der erfindungsgemäßen Schutzschaltung.

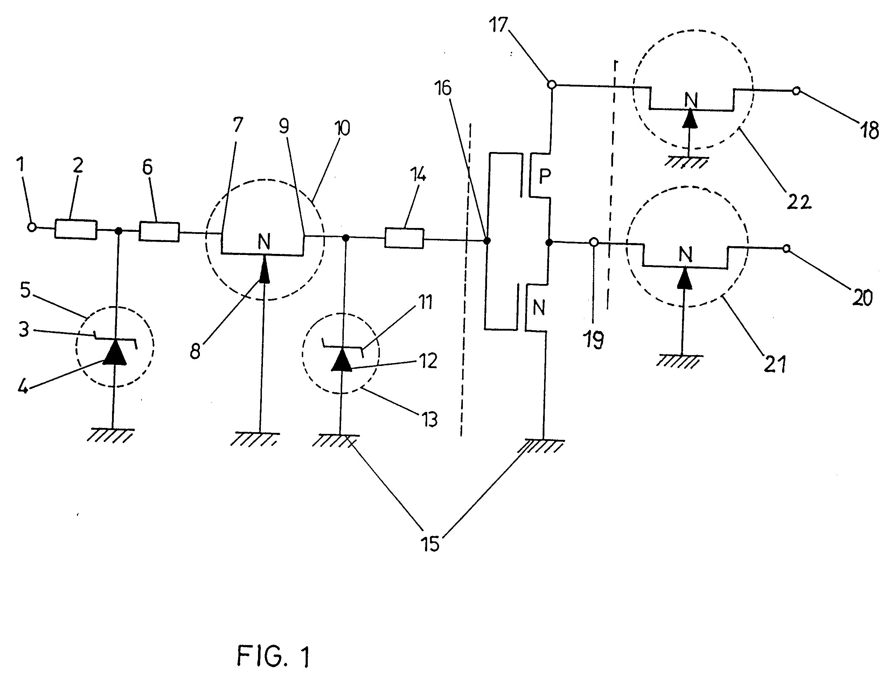

Gemäß Fig.1 ist ein Eingang 1 über einen Widerstand 2 auf die Kathode 3 einer Zenerdiode 5 geführt. Die Anode 4 der Zenerdiode 5 ist an Masse geschaltet. Ein weiterer Widerstand 6 ist von der Kathode 3 auf das Drain 7 des n-Kanal-JFET 10 geführt. Das Gate 8 des n-Kanal-JFET 10 ist mit Masse 15 verbunden. Vom Source 9 des n-Kanal-JFET 10 ist ein Widerstand 14 auf den Knotenpunkt 16 geführt. Der Knotenpunkt 16 ist die Zusammenschaltung der zu schützenden Gates. Die Anode 12 der Zenerdiode 13 ist mit Masse 15 verbunden, während die Kathode 11 mit dem Source 9 des n-Kanal-JFET 10 zusammengeschaltet ist.

In einer Variante sind Dioden vom Knotenpunkt 16 zur Betriebsspannung 17 und vom Knotenpunkt 16 nach Masse 15 vorgesehen.

Dynamisch wirkt die Schutzschaltung wie folgt: Bei normalen Spannungspegeln von 5 ... 7 Volt am Eingang 1 ist der n-Kanal-JFET 10 niederohmig. Die Bahnwiderstände 2, 6, und 14 liegen ebenfalls im Bereich von einigen hundert Ohm, so daß das Eingangssignal fast ungedämpft zum Knotenpunkt 16 der zu schützenden Gates gelangt. Die Durchbruchspannung der Zenerdiode 5 liegt bei 100 ... 200 Volt, die der Zeneraiode 13 bei etwa 10 ... 20 Volt und der n-Kanal-JFET 10 soll eine Pinch-off-Spannung von etwa -10 Volt aufweisen.

Steigt nun die Eingangsspannung am Eingang 1 auf etwa 10 Volt an, so wird der n-Kanal-JFET sehr hochohmig, weil Source und Drain gegenüber dem Gate positiv vorgespannt sind und somit den Kanal fast vollständig abschnüren.

Bei einem weiteren Spannungsanstieg wird der n-Kanal-JFET 10 vollständig gesperrt, und es erfolgt keine Spannungserhöhung am Knotenpunkt 16. Die Spannung am Knotenpunkt 16 wird auf den Wert der Pinch-off-Spannung des n-Kanal-JFET 10 festgeklemmt.

Sollte durch eine kapazitive Kopplung zwischen Drain und Source des n-Kanal-JFET 10 eine geringe Spannungsüberhöhung am Source 9 auftreten, so wird die Spannung durch die Zenerdiode 13 auf einen Wert von 12 Volt begrenzt.

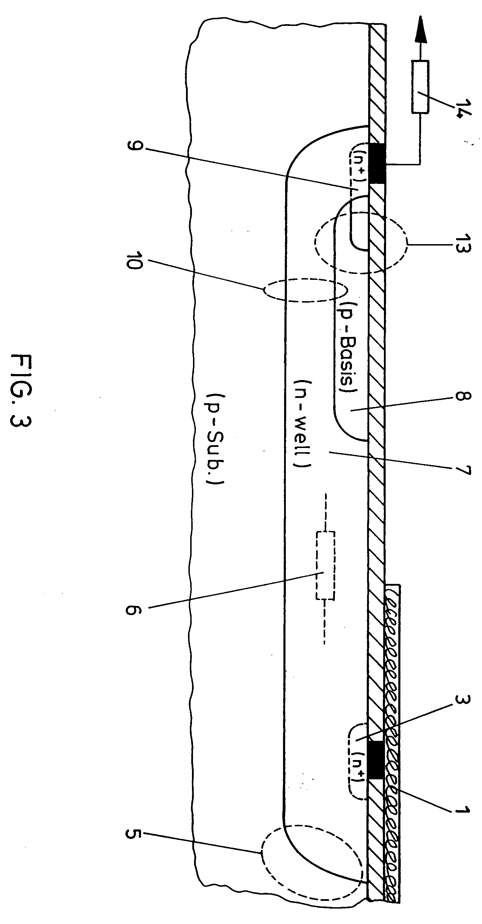

Bei sehr hohen Störspitzen bricht die Eingangszenerdiode 5 durch. Die Spitzenströme werden durch den Bahnwiderstand 2 begrenzt. Zweckmäßigerweise liegt dieser Bahnwiderstand der Bondinsel, wie in Fig.3 angedeutet, als Kontakt- und Ausbreitungswiderstand. Diese Anordnung hat weiterhin den Vorteil, daß keine Verkopplung von Eingang und Betriebsspannung über eine Diode auftritt.

Ein n-Kanal-JFET dieser Art kann nicht nur einen Eingang gegen Überspannungen schützen, sondern auch den Ausgang und den Betriebsspannungsanschluß.

Von der internen Betriebsspannung 17 ist ein weiterer n-Kanal-JFET 22 auf die Bondinsel 18 für den externen Betriebsanschluß geführt.

Ebenfalls vom internen Ausgangsanschluß 19 ist ein weiterer n-Kanal-JFET 21 auf die Bondinsel 20 für den externen Ausgangsanschluß geführt. In beiden Fällen ist das Gate der n-Kanal-FET's mit Masse zusammengeschaltet.

Die Spannungen können extrem unterschiedlich sein.

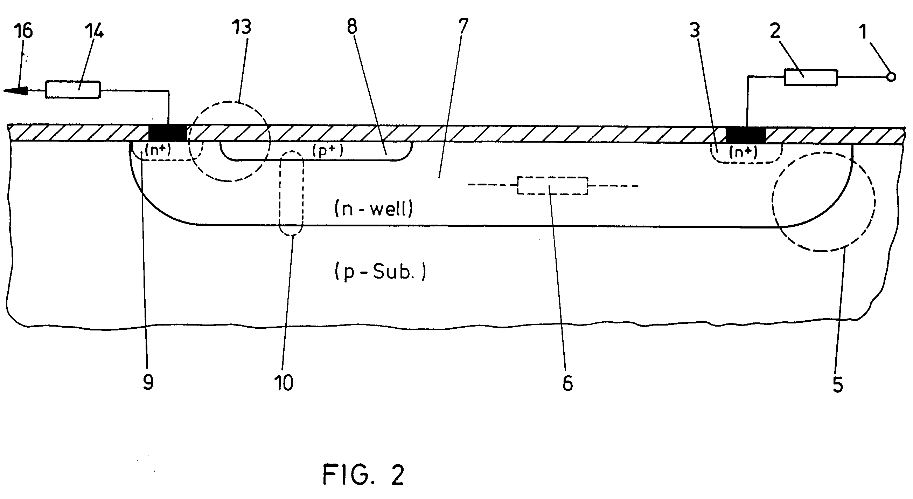

Fig. 2 zeigt eine integrierte Ausführungsform für einen n-Wannen-CMOS-Prozeß. In einer n-Wanne (n-well), die teilweise unter der Bondinsel liegen kann, sind das $p^+$-Gate 8 und die $n^+$-Gebiete 3, 9 vorgesehen. Das $p^+$-Gate 8 ist über den n-Wannenrand hinausgeführt und ist somit gleichzeitig mit dem $p^-$-Substrat, d.h. mit Masse 15 verbunden.

Der Bahnwiderstand 2 ist z.B. durch den Kontakt- und Ausbreitungswiderstand bzw. durch einen zusätzlichen Polysiliziumvorwiderstand realisiert.

Der Bahnwiderstand 6 ist ein diffundierter Widerstand, der durch das n-Wannengebiet gebildet ist. Der Bahnwiderstand 14 ist z.B. ein reiner Polysiliziumwiderstand.

Die Zenerdiode 13 ist als laterale Zenerdiode ausgebildet, wobei die Zenerspannung durch den lateralen $n^+$-$p^+$-Abstand eingestellt wird. Der Wert der Zenerspannung ist unkritisch, muß jedoch oberhalb des Wertes der Pinch-off-Spannung des n-Kanal-JFETSs 10 liegen.

Die Zenerdiode 5 ist durch den n-Wannenkopf zum $p^-$-Substrat realisiert.

Fig.3 zeigt eine integrierte Ausführungsform für einen n-Wannen-BICMOS-Prozeß. In einer n-Wanne (n-well), die auch hier wieder teilweise unter der Bondinsel liegen kann, sind das p-Gate 8 in Form eines p-Basisgebietes und die $n^+$-Gebiete 3, 9 angeordnet. Das $n^+$-Gebiet 9 überlappt die p-Basis 8 so, daß hier eine vertikale Zenerdiode 13 wirksam wird, wobei die Zenerspannung durch die Konzentrationen vorgegeben wird und bei etwa 4 ... 6 Volt liegt. Dafür ist das p-Gate 8 aber tiefer eindiffundiert, so daß die Pinch-off-Spannung des n-Kanal-JFET 10 bei etwa -5 ... -7 Volt liegen wird.

Alle anderen Bauelemente entsprechen der integrierten Ausführungsform gemäß Fig.2.

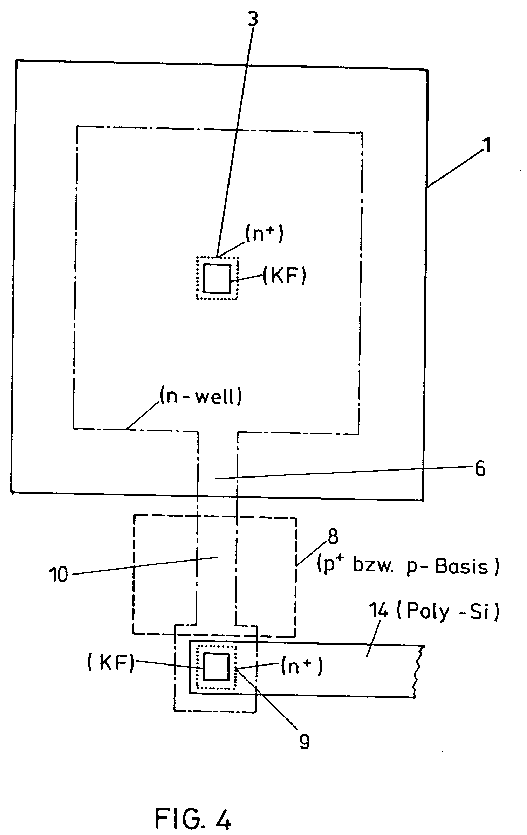

Fig.4 zeigt ein Layoutbeispiel der erfindungsgemäßen Eingangsschutzschaltung.

Unterhalb der Bondinsel 1 liegt der n-Wannenkopf mit dem n+-Gebiet 3. Die Ausgestaltung dieses n-Wannenkopfes ist beliebig. Er kann größer oder kleiner als die Bondinsel 1 selbst sein.

Die Länge des Bahnwiderstandes 6 ist entsprechend den dynamischen Anforderungen zu wählen. Gleiches gilt für den n-Kanal-JFET 10.

Die Durchbruchspannung der Zenerdiode 13 wird in diesem Beispiel durch den bestand des n+-Gebietes 9 und des P+-Gates 8 eingestellt. Verschiedene andere Layoutformen der einzelnen Bauelementegebiete sind möglich.

Das dynamische Verhalten der Schaltungsanordnung wird durch die großflächigen Dioden nicht negativ beeinflußt, weil die spezifischen Kapazitäten der n-Wanne (n-well) zum p⁻-Substrat auf Grund der geringen Konzentrationen und großen Eindringtiefe kleine Werte aufweisen.

## Patentansprüche

1. Schutzschaltung für die Gate-Elektrode von integrierten CMOS/BICMOS-Schaltungsanordnungen, bei welcher in der Zuleitung des zu schützenden Gates ein Feld-Effekt-Transistor vom selbstleitenden Typ angeordnet ist, dessen Gate an Masse liegt, dadurch gekennzeichnet, daß der FET als n-Kanal-JFET (10) ausgebildet ist, wobei sich ein elektrisches Ersatzschaltbild ergibt, bei welchem ein Eingang (1) über einen ersten Widerstand (2) auf die Kathode (3) einer ersten Zenerdiode (5) geführt ist, die Anode (4) der ersten Zenerdiode (5) an Masse (15) angeschaltet ist, ein zweiter Widerstand (6) zwischen der Kathode (3) der ersten Zenerdiode (5) und dem Drain (7) des n-Kanal-JFET (10) vorgesehen ist, das Gate (8) des n-Kanal-JFET (10) mit der Kathode einer zweiten Zenerdiode (13) zusammengeschaltet ist, die Anode (12) der zweiten Zenerdiode (13) mit Masse (15) verbunden ist und zwischen dem Source (9) des n-Kanal-JFETs (10) und einem Knotenpunkt (16) der zu schützenden Gate-Elektroden ein weiterer Widerstand (14) vorgesehen ist.

2. Schutzschaltung nach Anspruch 1, dadurch gekennzeichnet, daß zwischen dem Knotenpunkt (16) und der Betriebs-spannung (17) eine Diode in Durchlaßrichtung vorgesehen ist.

3. Schutzschaltung nach den Ansprüchen 1 und 2, dadurch gekennzeichnet, daß zwischen dem Kontenpunkt (16) und Masse (15) eine Diode in Sperrichtung geschaltet ist.

4. Schutzschaltung nach Anspruch 1, 2 oder 3, dadurch gekennzeichnet, daß der n-Kanal-JFET (10) als vertikaler Transistor ausgebildet ist.

5. Schutzschaltung nach einem der Ansprüche 1 bis 4, dadurch gekennzeichnet, daß ein weiterer n-Kanal-JFET (22) vom Anschluß (17) auf den Anschluß (18) geführt ist, wobei das Gate mit Masse (15) verbunden ist.

6. Schutzschaltung nach einem der Ansprüche 1 bis 5, dadurch gekennzeichnet, daß ein weiterer n-Kanal-JFET (21) vom Anschluß (19) auf den Anschluß (20) geführt ist, wobei das Gate mit Masse ( 15 ) zusammengeschaltet ist.

7. Verfahren zur Herstellung einer Schutzschaltung nach einem der Ansprüche 1 bis 6, dadurch gekennzeichnet, daß bei einem n-Wannen-CMOS-Prozeß die Zenerdiode (5) aus einem Kopfteil der n-Wanne ausgebildet wird, daß der Widerstand (6) durch einen länglichen Teil der n-Wanne realisiert wird, daß der n-Kanal-JFET (10) aus dem Teil der n-Wanne gebildet wird, der unter dem p+-Gate (8) liegt, und daß die Zenerdiode (13) im Bereich des n+-Source (9) und des p+-Gate (8) wirksam ist.

8. Verfahren nach Anspruch 7, dadurch gekennzeichnet, daß der Kopfteil der n-Wanne unter der Bondinsel des Eingangs (1) angeordnet wird.

9. Verfahren zur Herstellung einer Schutzschaltung nach einem der Ansprüche 1 bis 6, dadurch gekennzeichnet, daß bei einem n-Wannen-BICMOS-Prozeß das p-Gate (8) durch die Basisdiffusion erzeugt wird und daß die Zenerdiode (13) durch den beim BICMOS-Prozeß zur Verfügung stehenden Emitter-Basis-pn-Übergang realisiert wird.

# FIG. 1

FIG. 2

EP 0 508 975 A1

## FIG. 3

FIG. 4

Europäisches
Patentamt

# EUROPÄISCHER RECHERCHENBERICHT

Nummer der Anmeldung

EP 92 89 0057

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 930 037 (WOO)<br>* Spalte 5, Zeile 14 - Zeile 21; Abbildung 4 *<br>--- | 1-9 | H01L27/02 |
| A | PATENT ABSTRACTS OF JAPAN<br>vol. 9, no. 230 (E-343)17. September 1985<br>& JP-A-60 085 553 ( HITACHI ) 15. Mai 1985<br>* Zusammenfassung *<br><br>----- | 1-9 | |
| | | | **RECHERCHIERTE SACHGEBIETE (Int. Cl.5)**<br><br>H01L |

Der vorliegende Recherchenbericht wurde für alle Patentansprüche erstellt

| Recherchenort | Abschlußdatum der Recherche | Prüfer |
|---|---|---|
| DEN HAAG | 20 JULI 1992 | VENDANGE P. |

**KATEGORIE DER GENANNTEN DOKUMENTE**

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes
    Dokument

EPO FORM 1503 03.82 (P0403)